Europäisches Patentamt

European Patent Office

Office européen des brevets

(19)

(11) Numéro de publication: **0 097 565**

**A1**

(12)

# DEMANDE DE BREVET EUROPEEN

(21) Numéro de dépôt: **83401157.9**

(22) Date de dépôt: **07.06.83**

(51) Int. Cl.³: **H 03 K 3/86**
**G 01 S 7/40, G 01 S 7/38**

(30) Priorité: **18.06.82 FR 8210704**

(43) Date de publication de la demande:
**04.01.84 Bulletin 84/1**

(84) Etats contractants désignés:
**DE GB IT NL**

(71) Demandeur: **THOMSON-CSF**
**173, Boulevard Haussmann**
**F-75379 Paris Cedex 08(FR)**

(72) Inventeur: **Peyrat, André**
**THOMSON-CSF SCPI 173, bld Haussmann**
**F-75379 Paris Cedex 08(FR)**

(74) Mandataire: **Benoit, Monique et al,**
**THOMSON-CSF SCPI 173, Bld Haussmann**
**F-75379 Paris Cedex 08(FR)**

(54) Générateur d'impulsions fixes et/ou mobiles à retard arbitrairement grand et controlable par incréments.

(57) Générateur d'impulsions comportant une ligne à retard
(1) simple à retard fixe, et un amplificateur (6) à gain variable,
connecté entre la sortie et l'entrée de ladite ligne.
Application au domaine radar.

FIG_1

EP 0 097 565 A1

1

# GENERATEUR D'IMPULSIONS FIXES ET/OU MOBILES A RETARD ARBITRAIREMENT GRAND ET CONTROLABLE PAR INCREMENTS

La présente invention concerne un générateur d'impulsions fixes et/ou mobiles à retard arbitrairement grand et contrôlable par incréments. Un tel générateur est réalisé autour d'une ligne à retard simple et de retard fixe et permet d'obtenir une suite d'impulsions décalées dans le temps dont il est possible à volonté de contrôler le nombre et le niveau ; il est également possible de sélectionner une ou plusieurs desdites impulsions ainsi créées. Ce générateur est plus particulièrement un générateur hyperfréquence.

Une ligne à retard est un dispositif dans lequel l'injection à l'entrée d'un signal haute fréquence impulsionnel produit en sortie un signal identique mais décalé dans le temps d'une quantité constante et caractéristique de la ligne appelée le retard de la ligne. Une telle ligne est une ligne dite simple mais il existe des lignes à impulsions multiples, dans lesquelles l'introduction d'un signal haute fréquence impulsionnel à l'entrée produit en sortie non pas un signal unique mais un train de signaux retardés dans le temps chacun d'une durée fixe par rapport au précédent, le temps de retard entre les échos ne dépendant que des caractéristiques de la ligne et "étant à ce titre parfaitement constant et répétitif".

Ce type de dispositif est réalisable actuellement dans les techniques dites à ondes de surface ou à ondes de volume dans lesquelles le retard du signal est obtenu par une double transformation du signal, de signal électromagnétique en signal acoustique puis de signal acoustique en signal électromagnétique, la relative lenteur de la propagation du signal acoustique créant le retard temporel existant entre le signal d'entrée et le ou les signaux de sortie. Les lignes à retard simples caractérisées par un retard de l'ordre de la microseconde ou de quelques microsecondes sont actuellement réalisables bien que leur fabrication soit complexe et délicate. Par contre, les lignes à impulsions multiples et les lignes à grand retard, de l'ordre de la dizaine ou de quelques dizaines de microsecondes, sont beaucoup plus difficiles à réaliser, en particulier à cause de la difficulté d'allonger le chemin parcouru par l'onde acoustique. De plus, le signal se trouve affecté d'une perte de niveau proportionnelle à la distance parcourue dans le matériau acoustique donc proportionnelle au retard de la ligne. Ceci implique que les lignes à grand retard ainsi réalisées présentent des pertes très importantes, prohibitives pour de nombreuses applications . De même dans les lignes à impulsions multiples proposées jusqu'àlors, les impulsions successives obtenues, décroissent en fonction de leur rang et ce, d'autant plus rapidement que le retard entre impulsions est plus grand.

Le but de l'invention est de réaliser par des moyens simples et peu coûteux un dispositif pouvant présenter les caractéristiques, soit d'une ligne à grand retard, soit d'une ligne à impulsions multiples tout en n'en présentant pas les inconvénients cités plus haut.

Dans ces conditions un tel générateur est particulièrement adapté à une utilisation dans le domaine radar pris dans son sens général. Ainsi la phase des impulsions délivrées par le générateur objet de l'invention étant parfaitement connue et stable, le générateur devient un générateur d'échos fixes et mobiles utilisable dans un équipement de test. Ce générateur peut aussi être utilisé comme pilote de radar à stabilité de phase améliorée, et également comme brouilleur. Ces utilisations pour être particulièrement intéressantes ne sont toutefois pas limitatives.

Suivant l'invention un générateur d'impulsions fixes et/ou mobiles à retard arbitrairement grand et contrôlable par incréments, utilisant une ligne à retard simple à retard fixe, est caractérisé en ce qu'il comprend un amplificateur à gain variable connecté entre la sortie et l'entrée de la dite ligne, compensant les pertes subies par les impulsions transitant dans les lignes et dans les circuits d'entrée et de sortie, l'ensemble de la dite ligne et de l'amplificateur consituant le générateur d'impulsions fixes et en ce qu'il comprend en outre des moyens connectables audit générateur d'impulsions fixes agissant sur le déphasage des impulsions qu'il délivre et transformant lesdites impulsions fixes en impulsions mobiles.

D'autres caractéristiques et avantages de l'invention apparaîtront dans la description qui suit, d'exemples de réalisations et d'applications, donnés à l'aide des figures qui représentent :

- la figure 1 : un générateur d'impulsions conformément à l'invention ;

- les figures 2, 3, 4 : l'allure des trains d'impulsions délivrés par le générateur de la figure 1 dans trois cas particuliers ;

- la figure 5 : la diminution périodique du gain de l'amplificateur entre les différents trains d'impulsions ;

- la figure 6 : la diminution du gain de l'amplificateur pendant le transit des impulsions dans la ligne à retard ;

- la figure 7 : comment se fait le choix d'une impulsion particulière dans un train ;

- la figure 8 : un générateur d'échos fixes et/ou mobiles suivant l'invention ;

- la figure 9 : un diagramme de la phase $\overline{\varphi}$ du déphaseur utilisé dans la figure 8 en fonction du temps ;

- la figure 10 un équipement de test de la stabilité d'un oscillateur local de radar utilisant le générateur conforme à l'invention.

Dans l'introduction à la présente description on a indiqué que le générateur d'impulsions suivant l'invention devait pallier les pertes subies lors de la propagation desdites impulsions dans la ligne utilisée, pertes d'autant plus grandes que la distance à parcourir dans le matériau de la ligne est plus grande si l'on désire obtenir en sortie du générateur des trains d'impulsions ou une impulsion fixe à grand retard. Actuellement, ces inconvénients sont liés aux lignes à retard dites à ondes de surface ou ondes de volume. Si l'on sait maîtriser dans cette technique la fabrication de lignes à retard à simple "écho", caractérisées par un retard de l'ordre de la microseconde ou de quelques microsecondes, il n'en est plus de même pour des lignes à impulsions ou échos multiples ou des lignes à grand

4

retard de l'ordre de la dizaine ou de quelques dizaines de microsecondes.

On notera que dans ce qui précède on a parlé "d'échos" pour caractériser les impulsions délivrées par le générateur d'impulsions suivant l'invention. Ceci s'explique par l'utilisation préférentielle de ce genre de générateur dans la technique radar comme il en ressortira dans la suite de la description.

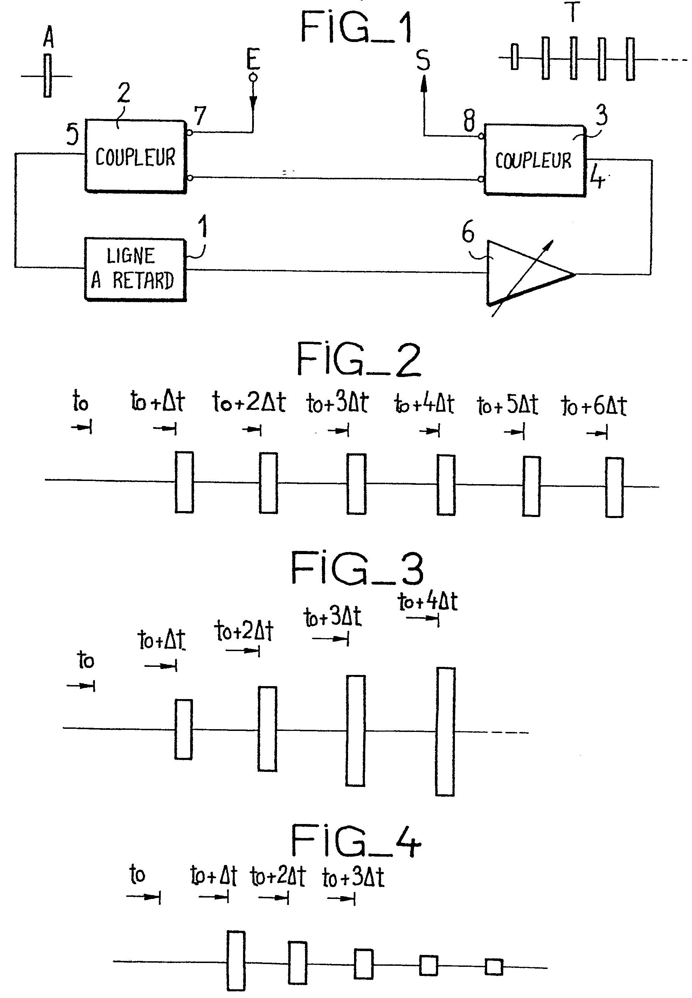

La figure 1 représente de façon extrêmement schématique, la partie générateur d'impulsions fixes du générateur d'impulsions conforme à l'invention. La ligne à retard utilisée 1 est connectée entre un dispositif d'entrée, un coupleur 2 par exemple et un dispositif de sortie, un coupleur 3 par exemple. En série avec la ligne à retard 1 entre la sortie 5 du coupleur d'entrée 2 et l'entrée 4 du coupleur de sortie 3, est disposé un amplificateur 6, à gain variable. L'entrée E du générateur est l'entrée 7 du coupleur d'entrée 2 et la sortie S du générateur est la sortie 8 du coupleur de sortie 3. La disposition des différents composants du générateur suivant l'invention n'est pas limitée à la représentation de la figure 1. Ces composants peuvent être placés différemment les uns par rapport aux autres sans que l'on sorte du cadre de l'invention. Le fonctionnement du générateur suivant l'invention tel que représenté figure 1 est le suivant :

L'ensemble de la ligne à retard 1 et de l'amplificateur 6 constitue une boucle telle que le signal qui la parcourt décrit un cycle dans lequel les pertes de la ligne 1 sont compensées en totalité ou en partie par le gain de l'amplificateur qui compense également les pertes dues aux coupleurs 2 et 3 qui permettent respectivement l'injection de signaux dans la boucle et leur prélèvement. Ainsi un signal impulsionnel A injecté sur l'entrée 7 du coupleur d'entrée 2 donne en sortie 8 du coupleur de sortie 3 un train d'impulsions T décalées dans le temps, l'une par rapport à l'autre d'une durée $\Delta t$ égale au retard de la ligne 1, augmenté du temps de transit dans le reste de la boucle.

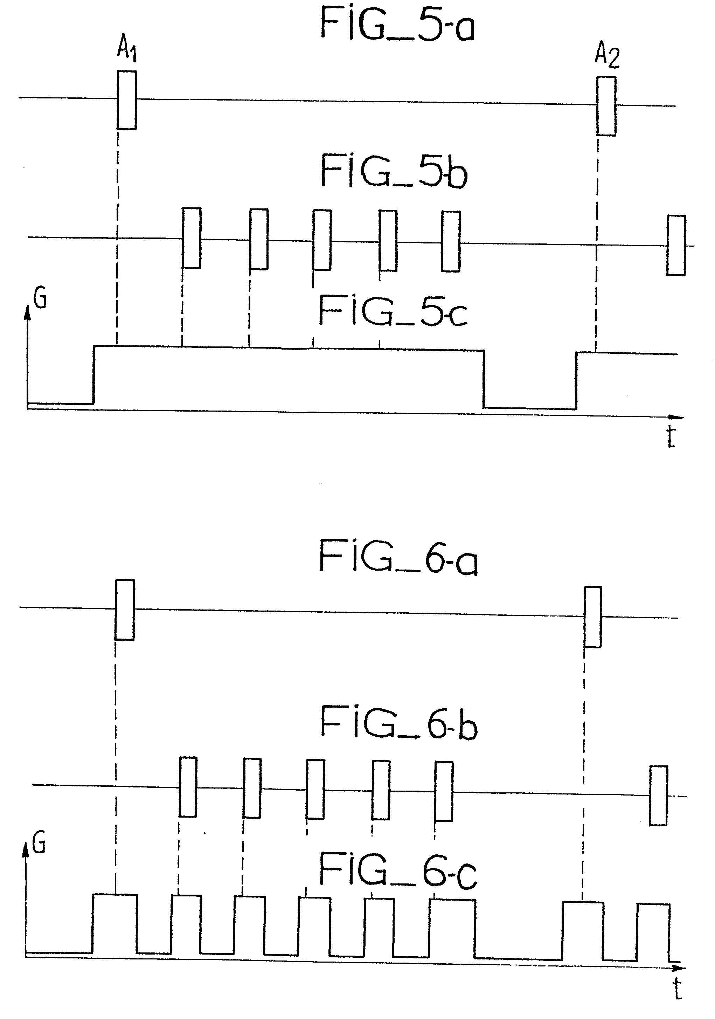

Suivant la valeur du gain de l'amplificateur, différentes configurations du train T d'impulsions de sortie du générateur peuvent être obtenues. Dans le cas où le gain de l'amplificateur est, pour la fréquence du signal d'entrée, égal ou supérieur aux pertes cumulées de la ligne et des coupleurs 2 et 3, le train d'impulsions conserve en fonction du temps une amplitude constante (figure 2) ou en augmentation d'une impulsion à la suivante (figure 3). La stabilité du système implique alors que le gain de l'amplificateur soit périodiquement abaissé de manière à empêcher l'entrée en oscillation du système, abaissement de gain que le spécialiste sait réaliser par plusieurs méthodes simples et peu coûteuses parmi lesquelles on peut citer, à titre d'exemple, l'insertion d'un modulateur en série avec l'amplificateur, le découpage de la tension d'alimentation d'un ou plusieurs étages de l'amplificateur ou l'action sur la commande de gain de l'amplificateur si elle existe. L'abaissement périodique du gain peut avoir lieu entre les différents trains d'impulsions correspondant aux impulsions injectées en entrée (figure 5) et également pendant que le signal est en transit dans la ligne à retard (figure 6).

La figure 2 représente un train d'impulsions de sortie du générateur dans le cas où pour la fréquence du signal A injecté à l'entrée 7 du coupleur d'entrée 2, le gain de l'amplificateur 6 est égal aux pertes cumulées de la ligne 1 et des coupleurs. Le train d'impulsions conserve, en fonction du temps une amplitude constante.

La figure 3 représente un train d'impulsions de sortie du générateur dans le cas où pour la fréquence du signal A injecté à l'entrée du coupleur d'entrée 2, le gain de l'amplificateur 6 est supérieur aux pertes cumulées de la ligne et des coupleurs. Les impulsions successives délivrées par le générateur au cours du temps ont une amplitude croissante.

La figure 4 représente un train d'impulsions de sortie du générateur dans le cas où pour la fréquence du signal A injecté à l'entrée du coupleur 2, le gain de l'amplificateur 6 est inférieur aux pertes cumulées de la ligne et des coupleurs. Les impulsions successives délivrées par le générateur au cours du temps ont une amplitude décroissante.

6

Suivant ce que l'on veut obtenir à la sortie du générateur il est ainsi nécessaire de pouvoir régler le gain de l'amplificateur. Maîtraiser le gain est d'autant plus nécessaire qu'il faut éviter que le système bouclé suivant l'invention entre en oscillation. Pour ce faire il faut périodiquement diminuer le gain de l'amplificateur. Ceci peut se faire de différentes manières dont celles qui ont été rappelées ci-dessus.

La figure 5 montre sur un diagramme en fonction du temps comment l'abaissement périodique du gain peut avoir lieu entre les différents trains d'impulsions correspondant aux impulsions injectées à l'entrée du système.

La figure 5a montre deux signaux d'entrée successifs A1 et A2.

La figure 5b montre le train d'impulsions de sortie à amplitude constante, et la figure 5c représente la variation du gain G de l'amplificateur en fonction du temps.

La figure 6 montre la commande du gain G de l'amplificateur dans le cas où celui-ci est abaissé pendant le transit de l'impulsion dans la ligne à retard. La commande du gain peut également se faire avec un modulateur mis en série avec l'amplificateur. On a indiqué dans l'introduction à la présente description que l'invention était particulièrement intéressante pour délivrer des trains d'impulsions. Ceci n'exclut pas que l'on puisse obtenir, si cela s'avère nécessaire une seule impulsion. Pour ce faire, on utilise un modulateur que l'on dispose à la sortie du système et que l'on commande pour n'être passant que pour l'impulsion choisie.

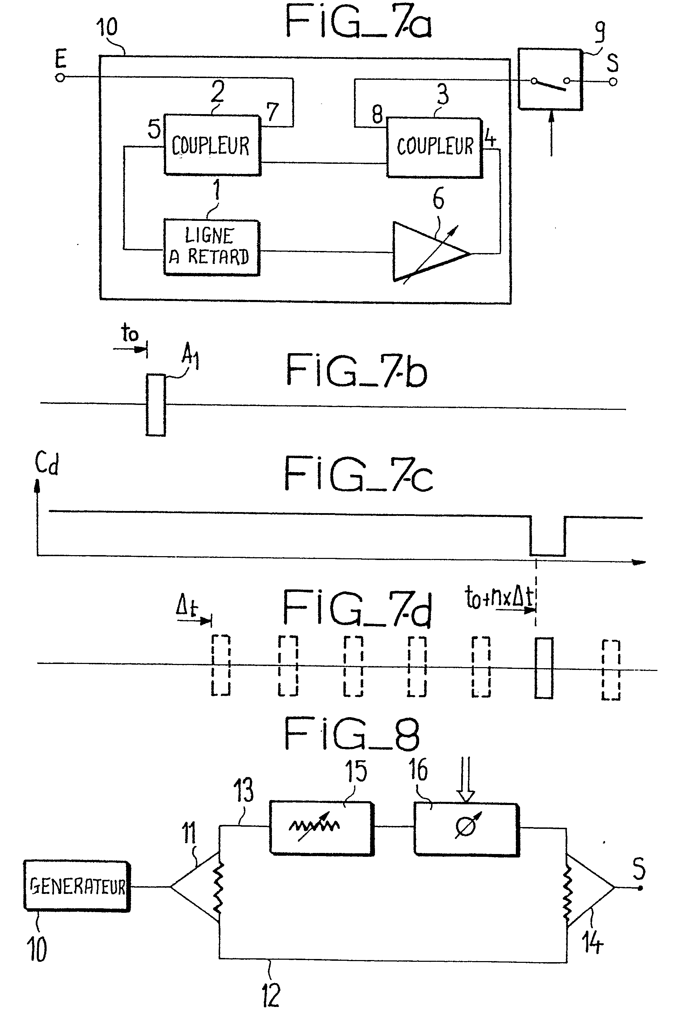

La figure 7 montre de façon schématique le montage correspondant avec des courbes de fonctionnement.

La figure 7a reproduit schématiquement la figure 1 avec la ligne à retard 1 et l'amplificateur 6 et les deux coupleurs 2 et 3 d'entrée et de sortie et le modulateur 9 connecté à la sortie du système.

La figure 7b montre le signal d'entrée $A_1$, au temps to.

La figure 7c montre la commande du modulateur en fonction du temps. Il est bloqué par exemple entre le temps to et le temps

to + n $\Delta$t, $\Delta$t étant le retard fixe de la ligne à retard 1, puis passant au temps (n+1) t et bloqué à nouveau. On voit aussi, par la courbe 7d qui représente le train d'impulsions de sortie du système que le signal choisi, le (n+1)$^{\text{ième}}$ par exemple, est délivré pendant l'ouverture du modulateur 9.

Les différentes réalisations qui ont été décrites ainsi qu'éventuellement d'autres réalisations qui en découlent suivant l'invention, sont ainsi définies à partir d'un dispositif comportant une ligne à retard simple à un seul écho et de retard $\Delta$t qu'il est relativement facile de construire alors qu'une ligne à grand retard, de retard n x $\Delta$t, n étant un nombre entier, ou une ligne à échos multiples de retard élémentaire $\Delta$t, avec le niveau du n ième écho parfaitement contrôlable, ne sont pas actuellement aisées à construire dans la technique des ondes de surface et des ondes de volume. On notera d'ailleurs comme avantage des réalisations suivant l'invention que la dégradation du rapport signal à bruit d'une impulsion à la suivante est très faible ; en effet, dans le cas par exemple où le niveau des échos successifs est maintenu constant, le calcul montre que si le facteur de bruit de l'amplificateur est F, la dégradation du rapport signal à bruit entre la première et la n ième impulsion retardée est de la forme :

$$\frac{1 + n \ x \ (F - 1)}{F}$$

Soit exprimé en décibels :

$$10 \log \frac{1 + n (F - 1)}{F}$$

Compte tenu des valeurs de F couramment observées, souvent inférieures à 2 décibels soit : F = 1,6, on voit que la dégradation est extrêmement faible comparée à ce qu'on observe sur les lignes à échos multiples de l'art antérieur où la dégradation du rapport signal à bruit entre la première et la n ième impulsion est de la forme :

$\propto$ + (n-1) $\Delta$t où $\Delta$t est le retard élémentaire et $\propto$ un coefficient dépendant des pertes dans le matériau acoustique, couramment de l'ordre de 1 décibel par microseconde. Suivant l'invention on peut donc obtenir des échos fortement retardés (n . Δt) présentant un rapport signal à bruit faiblement dégradé par rapport au rapport signal à bruit observé en sortie d'une ligne à un seul écho, de retard Δt.

On a fait remarquer dans l'introduction à la présente description que le générateur d'impulsions suivant l'invention trouvait des applications de choix dans le domaine radar où en particulier il était utilisable comme générateur d'échos fixes et/ou mobiles, dans un dispositif de test, dispositif de test pour la mesure de la stabilité de phase des pilotes de radar, pilote de radar à stabilité de phase améliorée par asservissement de la phase sur les impulsions successives délivrées par le générateur, et utilisable également dans un brouilleur de radar utilisant les impulsions successives sortant de la boucle à ligne à retard pour créer de nombreux échos décalés en distance et de mêmes caractéristiques.

On sait que la qualité principale demandée à un radar de surveillance est la capacité d'extraire parmi tous les signaux renvoyés vers lui par les différents obstacles situés dans le volume de couverture, ceux qui sont réfléchis par des objets dotés d'une vitesse rapide, c'est-à-dire ceux dont la distance au radar évolue au cours du temps et de rejeter ceux qui sont réfléchis par les obstacles fixes comme par exemple le sol, les bâtiments, les lignes électriques .... Pour distinguer ces échos différents, on fait un traitement dit d'élimination des échos fixes reçus d'une récurrence à la suivante. La capacité de discrimination entre les échos mobiles et les échos fixes (Subclutter visibility en anglais) est directement liée à la précision avec laquelle le radar est capable d'effectuer la comparaison de la phase d'une récurrence à la suivante. Parmi les nombreuses causes venant limiter cette capacité de discrimination d'un radar figurent les défauts de stabilité affectant les signaux utilisés à la réception pour la démodulation du signal reçu. Ces signaux au nombre de 2 en général, appelés respectivement Stalo et Coho dans la littérature anglo-saxonne possèdent avec l'impulsion émise une relation de phase constante et répétitive, soit naturelle dans le cas d'un radar à amplification de puissance, soit acquise dans le cas d'un radar à oscillateur pulsé. Pendant le temps aller et retour de l'impulsion radar, les oscillateurs Stalo et Coho continuent d'osciller et la démodulation de l'écho de retour d'un obstacle donné se fait à la fin du temps aller-retour. Dans le cas idéal où l'oscillation du Stalo et du Coho se reproduit pendant le temps d'aller-retour, de façon absolument identique d'une récurrence à la suivante, la phase de l'écho reçu est après démodulation par le Stalo et le Coho :

    - parfaitement constante et répétitive d'une récurrence à la suivante dans le cas d'un écho fixe ;

    - dans le cas fréquent d'un écho mobile se superposant à un écho fixe, affectée de variations d'une récurrence à la suivante qui ne sont dues qu'à l'obstacle mobile.

    Cependant dans la réalité, l'oscillation du Stalo et du Coho n'est pas strictement répétitive d'une récurrence à l'autre pendant le temps aller-retour de l'impulsion radar. Tributaire des instabilités propres affectant ces signaux, l'oscillation accuse une non-constance de la phase du signal reçu une fois démodulé par le Stalo et le Coho et ce même dans le cas d'un obstacle parfaitement fixe. Cette variation de phase revient à superposer à chaque écho fixe reçu, un écho mobile parasite dont l'amplitude relative par rapport à l'écho fixe porteur est proportionnelle aux variations de phase cumulées du Stalo et du Coho durant le temps aller-retour entre une recurrence et la suivante.

    Pour remédier à ces inconvénients, il faut pour ce type de radar, d'une part, concevoir des oscillateurs performants pour générer les signaux Stalo et Coho et d'autre part concevoir des équipements de test capables de mesurer les instabilités de phase très faibles de ces oscillateurs avec une précision suffisante afin de garantir qu'ils sont aptes au rôle qui est le leur.

    Pour le deuxième point, le générateur suivant l'invention est utilisable comme équipement de test d'un système radar ; on injecte à l'entrée du système par exemple représenté sur la figure 1, un échantillon de l'impulsion d'émission du radar, cet échantillon pouvant être prélevé en un point quelconque de la chaîne d'émission, même près de l'antenne et même après rayonnement par celle-ci. En sortie du système, on dispose de toute une série d'échos parfaitement stables simulant des échos fixes et présentant l'avantage de présenter un rapport signal à bruit important quel que soit le rang de l'échos et d'être parfaitement fixes, c'est-à-dire caractérisés par un décalage temporel parfaitement constant.

Un des problèmes associé à un radar à élimination des échos fixes étant, outre l'élimination de ces échos fixes de conserver les échos mobiles qui sont caractérisés par un temps aller-retour radar-cible non constant d'une impulsion à la suivante, on peut utiliser pour tester la chaîne d'émission, le récepteur, le traitement et surtout l'ensemble du radar, antenne tournante ou fixe éventuellement comprise, le générateur de la figure 8 pour simuler des échos mobiles de niveau et de vitesse relative variables. Le circuit 10 représente le générateur d'échos fixes tels que montré par exemple figure 1. La sortie de ce circuit 10 est connectée à un coupleur 11 connecté à deux voies en parallèle 12 et 13. L'une d'elles 12 transmet les échos fixes à un coupleur de sortie 14, l'autre 13 comprend en série un atténuateur variable 15 suivi d'un déphaseur 16 à commande électronique, de préférence. Cette voie 13 crée ainsi des échos mobiles qui sont transmis à travers le coupleur de sortie 14 à la sortie S du système complet qui reçoit le mélange des échos fixes et mobiles.

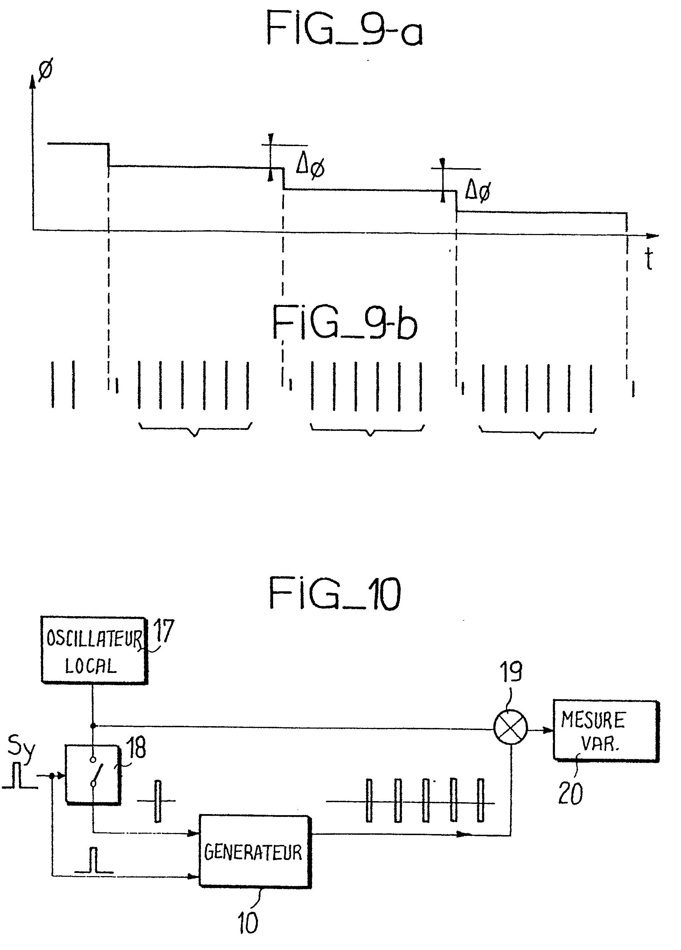

Le déphaseur 16 commandé électroniquement change d'état après chaque train d'échos ou, ce qui revient au même, avant chaque impulsion entrant dans le générateur d'écho comme le montre la figure 9 où la courbe 9a représente la phase $\phi$ affichée sur le déphaseur 16 en fonction du temps t et la figure 9b les trains d'échos obtenus.

On sait que cette action transforme les échos fixes présents à l'entrée du déphaseur en échos dits mobiles, c'est à dire, simulant les ondes renvoyées par les cibles mobiles. De fait, la vitesse radiale de

11

déplacement de la cible ainsi simulée peut varier au gré de l'utilisateur qui fait varier la différence de déphasage $\Delta\bar{\Phi}$ entre une récurrence et la suivante introduisant un retard $\frac{\Delta\Phi}{2\pi f}$, f étant la fréquence du radar. L'atténuateur 15 connecté au déphaseur 16 avant le coupleur de sortie 14 permet de doser le niveau des échos mobiles superposés aux échos fixes.

Le générateur d'échos fixes suivant l'invention est utilisable également pour la mesure de la stabilité des oscillateurs locaux de radars. Comme on le sait, la grandeur mesurée est la variation de la différence entre la phase du signal à un instant t et la phase du signal à l'instant $t + \Delta\theta$, $\Delta\theta$ étant en général fixé à plusieurs dizaines de microsecondes voire quelques centaines.

La figure 10 représente le montage de cet équipement de test. L'oscillateur local 17 dont on veut mesurer la stabilité est connecté au générateur d'échos fixes 10, suivant l'invention, à travers un interrupteur 18. La sortie du générateur 10 est connectée à un mélangeur 19 connecté également à l'oscillateur local 17. Le fonctionnement de ce dispositif est le suivant.

Un échantillon de signal de l'oscillateur 17, à l'instant t, est injecté dans le générateur d'écho 10 et on compare ensuite la phase du signal non retardé avec la phase des signaux retardés disponibles en sortie du générateur d'échos 10, dans un mélangeur 19 ; un signal de synchronisation Sy est appliqué d'une part à l'interrupteur 18 qu'il ferme et d'autre part au générateur 10.

L'analyse dans le circuit 20 des variations des signaux de sortie du mélangeur 19 donne la grandeur à mesurer pour des valeurs discrètes de $\Delta\theta$ égales à n fois le retard élémentaire t de la ligne. La mesure ainsi faite est simple et fiable et ne présente pas les limitations des méthodes classiques basées en général sur l'utilisation d'un oscillateur cohérent dont l'instabilité propre limite la précision de la mesure.

D'autres utilisation de ce générateur d'échos fixes suivant l'invention peuvent être citées.

Par exemple, un pilote de radar à grande stabilité de la phase.

12

Celle-ci en effet est asservie sur les impulsions successives sortant de la ligne à retard.

Par exemple encore, un dispositif brouilleur de radar. On utilise dans ce cas, les impulsions successives sortant de la boucle à ligne à retard suivant l'invention, pour créer de nombreux échos décalés en distance et de mêmes caractéristiques.

On a ainsi décrit un générateur d'impulsions fixes et/ou mobiles à retard arbitrairement grand et contrôlable par incréments.

# REVENDICATIONS

1. Générateur d'impulsions fixes à retard arbitrairement grand contrôlable par incrément, comprenant une ligne à retard (1) rebouclée par un amplificateur (6), des moyens d'injection (2) d'un signal haute fréquence impulsionnel et des moyens (3) de prélèvement des trains d'impulsions décalées dans le temps, obtenus à partir du signal impulsionnel, caractérisé en ce que l'amplificateur (6) présente un gain commutable dans le temps, entre deux niveaux.

2. Générateur selon la revendication 1, caractérisé en ce que le gain de l'amplificateur (6) est commuté périodiquement sur le niveau le plus bas entre chaque train d'impulsions.

3. Générateur selon la revendication 1, caractérisé en ce que le gain de l'amplificateur (6) est commuté sur le niveau le plus bas pendant que le signal impulsionnel est en transit dans la ligne à retard (1) et entre chaque train d'impulsions.

4. Générateur selon l'une des revendications 1, 2 ou 3 pour des impulsions fixes et/ou mobiles, caractérisé en ce qu'il comprend en outre des moyens agissant sur le déphasage des trains des impulsions fixes obtenues en sortie des moyens de prélèvement (3), lesdits moyens transformant en totalité ou en partie les impulsions fixes en impulsions mobiles.

5. Générateur selon la revendication 4, caractérisé en ce que les moyens agissant sur le déphasage des trains d'impulsions fixes comprennent :
   - un circuit atténuateur variable (15),
   - un circuit déphaseur (16) à déphasage variable, connecté audit atténuateur (15).

6. Générateur selon la revendication 5, caractérisé en ce que le circuit déphaseur (15) change de phase après chaque train d'impulsions fixes ou après chaque impulsion du signal d'entrée injecté dans les moyens (2).

7. Générateur selon l'une des revendications 4, 5 ou 6, utilisable dans un équipement radar, caractérisé en ce que les moyens agissant sur le déphasage des trains d'impulsions fixes constituent une première voie (13) connectée à la sortie des moyens (3) de prélèvement des trains d'impulsions et en ce que le générateur comprend en outre une deuxième voie (12) directe en parallèle sur la première, transmettant directement les échos fixes, lesdites deux voies se recombinant en sortie pour délivrer des échos fixes et mobiles.

8. Générateur selon la revendication 7, caractérisé en ce qu'il comprend :

- un coupleur (11) connecté en entrée aux moyens de prélèvement des trains d'impulsions fixes et en sortie aux deux voies parallèles (12 et 13),
- un coupleur (14) connecté en entrée aux deux voies parallèles (12 et 13) qu'il recombine et dont la sortie délivre des échos fixes et mobiles.

9. Générateur selon l'une quelconque des revendications 1 à 3, caractérisé en ce qu'il comprend en outre des moyens interrupteurs (9), connectés en sortie des moyens de prélèvement des trains d'impulsions fixes, commandés de façon à opérer le choix d'une impulsion déterminée parmi les trains d'impulsions fixes.

10. Générateur selon l'une quelconque des revendications 4 à 8, caractérisé en ce qu'il comprend en outre des moyens interrupteurs (9), connectés en sortie du coupleur (14), commandés de façon à opérer le choix d'une impulsion déterminée parmi les trains d'impulsions fixes.

11. Utilisation d'un générateur selon l'une quelconque des revendications 1 à 10 dans un dispositif de mesure de la stabilité d'un oscillateur local de radar, caractérisé en ce qu'un mélangeur (19) détermine le déphasage entre une impulsion issue de l'oscillateur local (17) du radar qui lui est appliqué directement et les impulsions retardées issues du générateur d'échos fixes (10) déclenché par cette même impulsion.

12. Pilote de radar à stabilité de phase améliorée, utilisant un générateur d'impulsions fixes (10) suivant l'une des revendications 1 à 3.

13. Brouilleur de radar utilisant un générateur d'impulsions fixes et/ou mobiles suivant l'une des revendications 1 à 10.

# FIG_1

# FIG_2

$t_0$  $t_0+\Delta t$  $t_0+2\Delta t$  $t_0+3\Delta t$  $t_0+4\Delta t$  $t_0+5\Delta t$  $t_0+6\Delta t$

# FIG_3

$t_0$  $t_0+\Delta t$  $t_0+2\Delta t$  $t_0+3\Delta t$  $t_0+4\Delta t$

# FIG_4

$t_0$  $t_0+\Delta t$  $t_0+2\Delta t$  $t_0+3\Delta t$

FIG_5-a

FIG_5b

FIG_5c

FIG_6-a

FIG_6-b

FIG_6-c

0097565

## FiG_7a

## FiG_7b

## FiG_7c

## FiG_7d

## FiG_8

FIG_9-a

FIG_9-b

FIG_10

OSCILLATEUR LOCAL 17

Sy

18

GENERATEUR

10

19

MESURE VAR.

20

Office européen
des brevets

# RAPPORT DE RECHERCHE EUROPEENNE

EP 83 40 1157

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| Y | GB-A-1 467 000 (MARCONI)<br><br>* Figure 1; page 2, lignes 41-46 *<br><br>--- | 1,2,4, 5,13 | H 03 K 3/86<br>G 01 S 7/40<br>G 01 S 7/38 |
| Y | DE-A-2 616 770 (SIEMENS)<br><br>* Figures 1,2; page 4, ligne 10 - page 7, ligne 4 *<br><br>--- | 1,2,4, 5,7,9 | |
| A | US-A-3 113 268 (HORAK)<br>* Figures; en entier *<br><br>--- | 1,3 | |
| A | US-A-4 164 741 (SCHMIDT)<br>* Figure 2; colonne 2, ligne 44 - colonne 3, ligne 2 *<br><br>--- | 1,2 | |
| A | US-A-4 328 496 (WHITE)<br>* Figures 1-3; colonne 1, ligne 64 - colonne 3, ligne 14 *<br><br>--- | 1,13 | **DOMAINES TECHNIQUES RECHERCHES (Int. Cl. ³)**<br><br>G 01 S<br>H 03 K |
| A | GB-A-1 532 777 (EMI)<br>* Figures 1,2; page 1, ligne 76 - page 2, ligne 52 *<br><br>--- | 1,13 | |
| A | US-A-3 883 810 (TACUSSEL)<br>* Figures 1,5; colonne 2, ligne 33 - colonne 3, ligne 19; colonne 4, ligne 52 - colonne 5, ligne 32 *<br><br>---    -/- | 1,12 | |

Le présent rapport de recherche a été établi pour toutes les revendications

| Lieu de la recherche<br>LA HAYE | Date d'achèvement de la recherche<br>23-09-1983 | Examinateur<br>FEUER F.S. |
|---|---|---|

## Office européen des brevets

## RAPPORT DE RECHERCHE EUROPEENNE

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|-----------|---------------------------------------------------------------------------------|-------------------------|----------------------------------------|
| A | US-A-4 145 691  (FREELING et al.)<br><br>----- | 1,9 | |

DOMAINES TECHNIQUES RECHERCHES (Int. Cl. ³)

Le présent rapport de recherche a été établi pour toutes les revendications

| Lieu de la recherche<br>LA HAYE | Date d'achèvement de la recherche<br>23-09-1983 | Examinateur<br>FEUER F.S. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03.82